# EUROPEAN PATENT APPLICATION

(11) **EP 1 801 869 A1**
(43) Date of publication of application: **27.06.2007**
(21) Application number: 04788045.5
(22) Date of filing: 24.09.2004
(51) Int. Cl.: H01L 21/68, B65G 49/07

(54) **CONTAINER CARRYING EQUIPMENT**

(71) Applicant: Hirata Corporation, Tokyo 142-0041 (JP)
(72) Inventor: TACHIBANA, Katsuyoshi, HIRATA CORPORATION, Tokyo 142-0041 (JP)
(74) Representative: Müller, Frank Peter
(86) International application number: PCT/JP2004/013886
(87) International publication number: WO 2006/035473

(57) **Abstract**

A container 3 airtightly stores articles, such as semiconductor wafers and liquid-crystal display panels, which are required to be transported with their surface kept uncontaminated. A container transport apparatus is used to transport the container 3 between a plurality of processing apparatuses 1-n within a bay area. The container transport apparatus includes a conveyor 5, which is arranged in a ceiling space within the bay area along a direction of arrangement of the plurality of processing apparatuses 1-n and which is adapted to move the container 3 in a state where the container 3 is placed on a pallet 6. The container transport apparatus also includes a lifting apparatus 7, which is provided for each load port 4 of the plurality of processing apparatuses 1-n disposed under the conveyor 5 and which is adapted to lift and lower the container 3 between the load port 4 and the conveyor 5, and a pallet insertion/removal means 20 for inserting the pallet 6 into a space above the conveyor 5 and removing the pallet 6 therefrom.

## Description

### TECHNICAL FIELD

The present invention relates to a container transport apparatus (container carrying equipment), and more particularly to a container transport apparatus which is used to transport, between a plurality of processing apparatuses, a container which airtightly stores articles, such as semiconductor wafers and liquid-crystal display panels, which are required to be transported with their surface kept uncontaminated.

### BACKGROUND ART

If dust or impurities such as vaporized organic substances adhere to surfaces of semiconductor wafers, the wafers are contaminated, resulting in lowered yield of products; i.e., lowered non-defective ratio. In order to overcome this problem, when wafers are conveyed between a plurality of different processing apparatuses, a plurality of wafers are accommodated within a highly clean, sealed container, which is called a FOUP (Front Opening Unified Pod), and are conveyed together with the FOUP. Further, it is important to maintain the transport space and the processing apparatuses themselves in a highly clean condition. Therefore, the space within a bay area which surrounds the processing apparatuses has been provided in the form of a clean room.

Incidentally, since maintaining such a clean room requires high cost, a matter of great interest is reducing the size of the clean room through rational arrangement of a transport apparatus, processing apparatuses, and working areas for workers.

In order to meet the requirement of reducing the size of the clean room, more generally, the size of the space within the bay area, a transport apparatus has conventionally been installed not on the floor but in a ceiling space. Such arrangement allows a space under the transport apparatus to be used as a standby location (buffer) for containers, allows the transport apparatus to have a multi-level configuration so as to increase transport capacity and transport efficiency, and allows the space under the transport apparatus to be used as working areas for workers, to thereby contribute to a reduction of cost for maintaining the clean room, an improvement in transport efficiency, etc.

Japanese kohyo (PCT) Patent Publication No. H14-532362 discloses a container transport apparatus of such a type which utilizes such an overhead-traveling-type transport apparatus. This transport apparatus, which is called an "integrated system for transporting articles," has a structure as described below. Notably, the term "article" used here refers to a container or the like, and does not refer to contents accommodated within the container or the like.

In a ceiling space within a bay area, a conveyor for moving the article is disposed along the direction of arrangement of a plurality of processing apparatuses. An elevator system is attached to the conveyor. This elevator system includes a lift device configured to engage the article carried by the conveyor and to raise the article above the conveyor. The lift device is movable between a stand-by position allowing movement of the article along the conveyor path past the lift device, and an actuated position at which the lift device holds the article above the conveyor.

This integrated system also includes a storage support assembly for supporting the article within a buffer zone; a displacement mechanism for moving the article between the actuated position of the lift device and the storage support assembly; a work station support assembly (load port) for supporting the article within a work station zone near a work station (processing apparatus); a transfer arm configured to move in a horizontal direction along the conveyor path and a vertical direction; a gripper mounted on the transfer arm and configured to grip the article; and a controller for controlling movement of the transfer arm. This transfer arm moves along the horizontal direction and the vertical direction within a region which is sandwiched between the conveyor and the work station as viewed from above so as to move the article between the storage support assembly and the work station support assembly.

Accordingly, this integrated system requires respective operations of the lift device, the displacement mechanism, and the transfer arm so as to transfer the article on the conveyor to the work station support assembly and transfer the article from the work station support assembly onto the conveyor. In addition, the storage support assembly, which supports the article within the buffer zone during such transfer operation, is required. Therefore, only a single combination of these apparatuses and mechanisms is required to transfer the article between the conveyor and the plurality of work stations; however, an increase arises in the types of the apparatuses and mechanisms, and the operation of the system becomes complex. Further, since the moving space of the transfer arm and the traveling space of the conveyor are adjacent to each other as viewed from above, there is still room for improvement for reducing the size of the space within the bay area; for example, a relatively large useless space is likely to be produced in particular under the conveyor. Moreover, in the integrated system, since the article is directly placed on the conveyor and is conveyed, it cannot be said that no impairment can arise in the transport stability.
Patent Document 1: Japanese kohyo (PCT) Patent Publication No. H14-532362

### DISCLOSURE OF THE INVENTION

### PROBLEM TO BE SOLVED BY THE INVENTION

An object of the present invention is to solve the above-mentioned problems in the conventional container transport apparatus and to provide a container transport apparatus which can further reduce the space within the bay area, and can transport containers more stably and safely.

### MEANS FOR SOLVING THE PROBLEM

According to the present invention, the above-described problems are solved by a container transport apparatus as follows.
That is, the container transport apparatus is used to transport a container between a plurality of processing apparatuses within a bay area. The container airtightly stores articles, such as semiconductor wafers and liquid-crystal display panels, which are required to be transported with their surface kept uncontaminated. The container transport apparatus includes a conveyor which is arranged in a ceiling space within the bay area to extend along a direction of arrangement of the plurality of processing apparatuses and which is adapted to move the container in a state where the container is placed on a pallet; a lifting apparatus which is provided for each load port of the plurality of processing apparatuses disposed under the conveyor and which is adapted to lift and lower the container between the load port and the conveyor; and a pallet insertion/removal means for inserting the pallet into a space above the conveyor and removing the pallet therefrom. The pallet insertion/removal means inserts the pallet into the space above the conveyor or removes the pallet therefrom in a state in which the lifting apparatus has lifted the container to a position slightly higher than the conveyor and holds the container at that position.

In the container transport apparatus, the lifting apparatus enables the pallet insertion/removal means to operate in such a manner that in a state in which the lifting apparatus lifts a container to a position slightly higher than the conveyor and holds the container at that position, the insertion/removal means inserts the pallet into a space above the conveyor or removes the pallet from the space above the conveyor in order to place the container into the conveyor line or remove the container from the conveyor line and lower the container to the load port.

As a result, through cooperation of two types of apparatus and means; i.e., the lifting apparatus and the pallet insertion/removal means, the container on the conveyor can be transferred to the load port of a predetermined processing apparatus, and the container can be transferred from the load port of the predetermined processing apparatus to the load port of another predetermined processing apparatus via the conveyor. Therefore, the overall operation of the container transport apparatus is relatively simplified, and its control is simplified.

Further, during a period in which the container is removed from the conveyor line, lowered to the load port, and is returned to the conveyor line through operation of the lifting apparatus and the pallet insertion/removal means, movement along the conveyor line of a container on the upstream side of the conveyor is not hindered.
Moreover, since the container is conveyed by the conveyor in a state in which the container is placed on the pallet, the container is transported in a more stable manner.

In a preferred embodiment, a vertical wall is provided between adjacent load ports, and a drive mechanism of the lifting apparatus is attached to the vertical wall. Therefore, the vertical wall serves as a safety cover, which prevents accidents such as easy falling of a container which is being transferred between the conveyor and the load port or a container placed on the load port, to thereby secure safety. Moreover, work safety can be secured for workers. In addition, since the vertical wall serves as a mount portion for the drive mechanism of the lifting apparatus, the lifting apparatus can be made compact.

### EFFECTS OF THE INVENTION

As described above, according to the container transport apparatus of the present invention, through cooperation of two types of apparatus and means; i.e., the lifting apparatus and the pallet insertion/removal means, the container on the conveyor can be transferred to the load port of a predetermined processing apparatus, and the container can be transferred from the load port of the predetermined processing apparatus to the load port of another predetermined processing apparatus via the conveyor. Therefore, the overall operation of the container transport apparatus is relatively simplified, and its control is simplified.

Further, during a period in which the container is removed from the conveyor line, lowered to the load port, and is returned to the conveyor line through operation of the lifting apparatus and the pallet insertion/removal means, movement along the conveyor line of a container on the upstream side of the conveyor is not hindered.
Moreover, since the container is conveyed by the conveyor in a state in which the container is placed on the pallet, the container is transported in a more stable manner.

Further, a vertical wall is provided between the adjacent load ports, and the drive mechanism of the lifting apparatus is attached to the vertical wall. Therefore, the vertical wall serves as a safety cover, which prevents accidents such as easy falling of a container which is being transferred between the conveyor and the load port or a container placed on the load port, to thereby secure safety. Moreover, work safety can be secured for workers. In addition, since the vertical wall serves as a mount portion for the drive mechanism of the lifting apparatus, the lifting apparatus can be made compact.

### BRIEF DESCRIPTION OF THE DRAWINGS

FIG. 1 is a perspective view of a portion of one bay area of a semiconductor manufacturing apparatus to which a container transport apparatus of an embodiment is applied.
FIG. 2 is an enlarged view of a portion of FIG. 1.
FIG. 3 is a front view of the portion of the bay area.
FIG. 4 is an enlarged view of a portion of FIG. 3.
FIG. 5 is a right side view of FIG. 4;
FIG. 6 is a front view of a vertical wall between adjacent load ports, showing lifting means accommodated in the interior of the vertical wall.
FIG. 7 is a left side sectional view of FIG. 6.

### BEST MODE FOR CARRYING OUT THE INVENTION

A container transport apparatus is used to transport a container between a plurality of processing apparatuses within a bay area. The container airtightly stores articles, such as semiconductor wafers and liquid-crystal display panels, which are required to be transported with their surface kept uncontaminated. The container transport apparatus includes a conveyor which is arranged in a ceiling space within the bay area to extend along a direction of arrangement of the plurality of processing apparatuses and which is adapted to move the container in a state where the container is placed on a pallet; a lifting apparatus which is provided for each load port of the plurality of processing apparatuses disposed under the conveyor and which is adapted to lift and lower the container between the load port and the conveyor; and pallet insertion/removal means for inserting the pallet into a space above the conveyor and removing the pallet therefrom. The pallet insertion/removal means inserts the pallet into the space above the conveyor or removes the pallet therefrom in a state in which the lifting apparatus has lifted the container to a position slightly higher than the conveyor and holds the container at that position. Further, a vertical wall is provided between adjacent load ports, and a drive mechanism of the lifting apparatus is attached to the vertical wall.

### EMBODIMENT

Next, an embodiment of the present invention will be described.
A bay area of a semiconductor manufacturing apparatus to which a container transport apparatus of the present embodiment is applied is configured in the form of a clean room, and contains a plurality of processing apparatuses for performing various processes on a semiconductor wafer to form integrated circuits thereon. In general, these processing apparatuses are aligned and arranged in a certain direction, and/or a plurality of groups each including a plurality of processing apparatuses aligned and arranged in a certain direction are disposed in parallel. In this manner, the layout of the processing apparatuses is determined so as to minimize the footprint of workpiece transport along the processing steps. In general, a semiconductor manufacturing apparatus is configured by connecting a plurality of such bay areas.

Meanwhile, a plurality of semiconductor wafers (workpieces) are typically stored in a FOUP, which is a highly clean sealed container, and are transported. Within the FOUP, the wafers are oriented horizontally and arranged at predetermined intervals in the vertical direction. When a predetermined process is performed for the wafers at each of the plurality of processing apparatuses aligned and arranged as described above, the wafers must be transferred between each of the plurality of processing apparatuses and the FOUP without being exposed to the outside, contaminated atmosphere. For such transfer, an interface called a FOUP opener is used.

A plurality of FOUP openers are typically attached to the wall portions of the processing apparatuses on the same side, and are aligned and arranged along the same direction as the direction of alignment of the plurality of processing apparatuses. Each of such FOUP openers includes a load port for positioning and supporting the FOUP at a predetermined position, and an opener for establishing communication between the interior of the FOUP and the interior of the processing apparatus while prohibiting entry of ambient air.

When the opener operates in the above-described manner, the load port causes a support base, which supports the FOUP, to approach the wall portion of the processing apparatus, to thereby allow the opener to open and close the door of the FOUP. The opener separates the door from the FOUP body (shell), holds the separated FOUP door, and retreats to a predetermined position within the processing apparatus where the opener does not hinder the transfer of the wafers. Further, the opener operates in the reverse sequence when the door of the FOUP is returned to the original position, and the FOUP body (shell) is sealed.

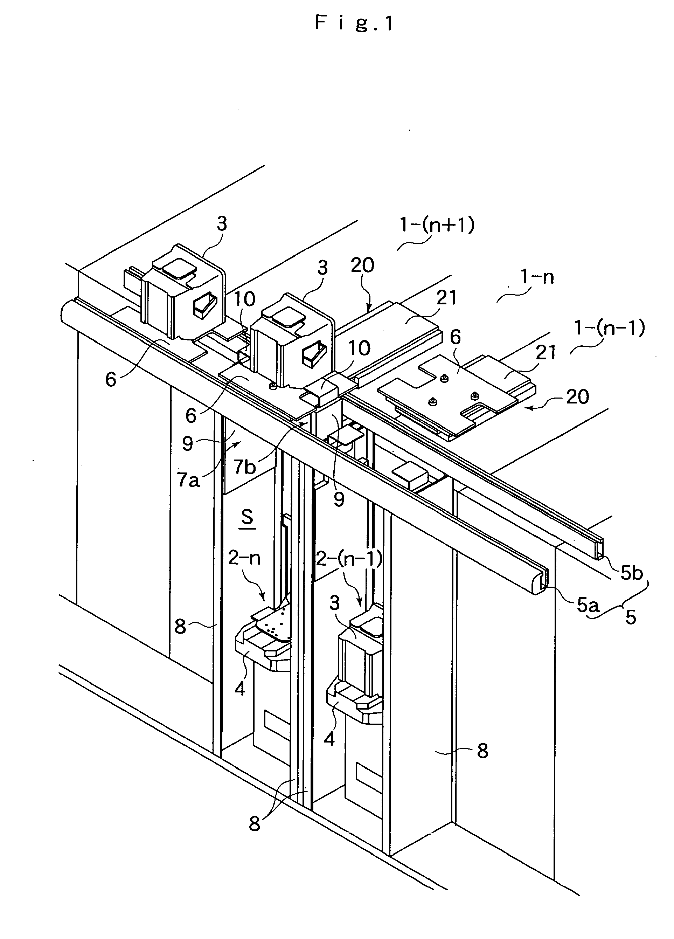

FIG. 1 shows a portion of one bay area which partially constitutes the semiconductor manufacturing apparatus. A plurality of processing apparatuses 1-1, 1-2, ···, 1-n, ··· are aligned and disposed along a certain direction. FOUP openers 2-1, 2-2, ···, 2-n, ··· are mounted to the respective front wall portions of these processing apparatuses. Each of the FOUP openers includes a load port 4 for positioning and supporting a FOUP 3 at a predetermined position, and an opener for establishing communication between the interior of the FOUP 3 and the interior of each processing apparatus 1-n while prohibiting entry of ambient air. The details of the opener are not shown in FIG. 1.

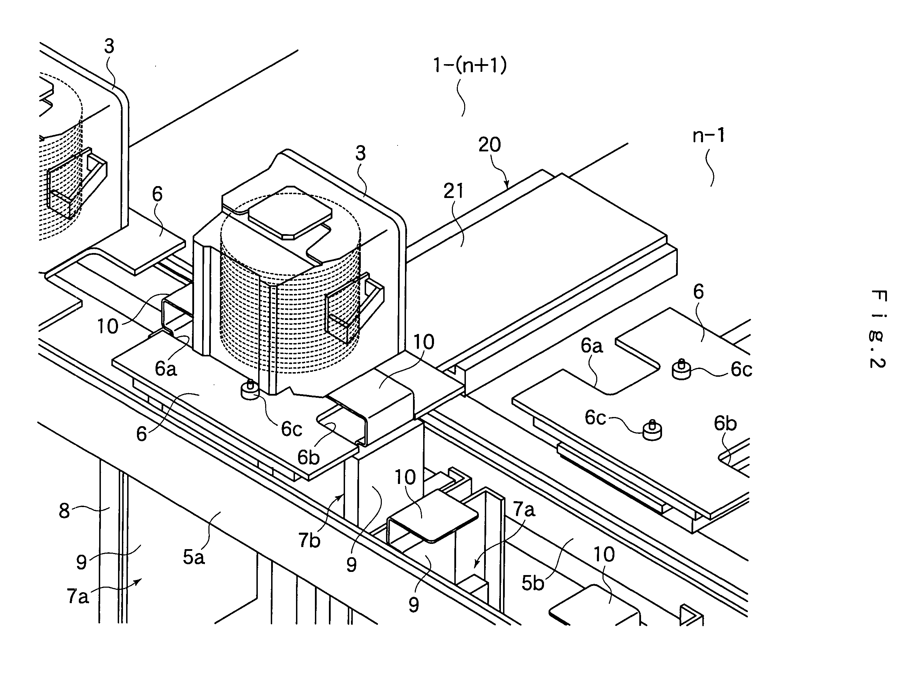

A conveyor 5 is disposed in a ceiling space within the bay area at a position immediately above the plurality of aligned load ports 4. This conveyor 5 is composed of paired left and right rails 5a and 5b, and an unillustrated drive mechanism. A plurality of rollers (not shown) are attached to the paired left and right rails 5a and 5b along the length direction thereof. Each of the FOUPs 3 is placed on a pallet 6 which straddles the paired left and right rails 5a and 5b and travels on the rollers of these rails, and is moved in this state by means of the conveyor 5. Squarish cut portions 6a and 6b are formed in front and rear portions of the pallet 6 with respect to the travel direction of the conveyor 5 to be located at respective central portions with respect to the transverse direction (see FIG. 2). Grasp nails 10 of a lifting apparatus 7 to be described later can vertically pass through these cut portions 6a and 6b.

Each load port 4 is equipped with the lifting apparatus 7 for lifting and lowering the FOUP 3 between the load port 4 and the conveyor 5. This lifting apparatus 7 is composed of two portions; i.e., a drive-side lifting apparatus portion 7a, and a driven-side lifting apparatus portion 7b, which cooperate to hold the FOUP 3 from both sides, and lift and lower the same. These two lifting apparatus portions 7a and 7b are each mounted on a vertical wall 8 between adjacent load ports 4, and a drive mechanism of the lifting apparatus 7 is accommodated within a vertically elongated concave space S of the vertical wall 8.

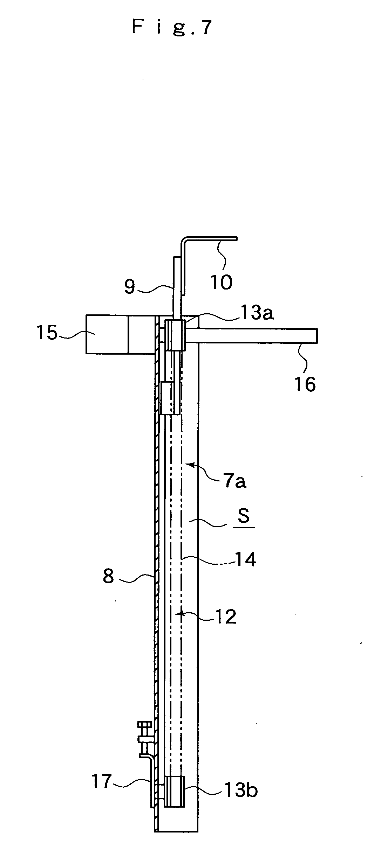

Next, the specific structure of the lifting apparatus 7 will be described.
As shown in FIG. 7, a reducer-equipped drive motor 15 is provided on the drive-side lifting apparatus portion 7a of the lifting apparatus 7. When the motor 15 rotates, the lifting apparatus portion 7a on the same side operates, and the rotational output of the motor 15 is transmitted to the driven-side lifting apparatus portion 7b via a counter shaft 16, whereby the driven-side lifting apparatus portion 7b operates in the same manner as does the drive-side lifting apparatus portion 7a. Accordingly, the drive-side lifting apparatus portion 7a and the driven-side lifting apparatus portion 7b have the same structure, except that the drive-side lifting apparatus portion 7a has the reducer-equipped drive motor 15.

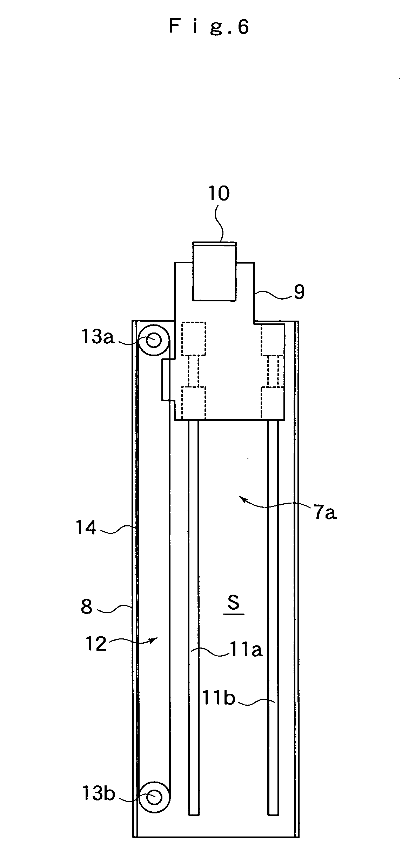

In view of the above, the structure of the lifting apparatus 7 will be described in detail, while the drive-side lifting apparatus portion 7a is taken as an example. As can be well seen from FIGS. 6 and 7, the lifting apparatus 7 is composed of a shoulder plate 9 having a relatively large area; an arm (grasp nail) 10 fixed to an upper end portion of the shoulder plate 9 and formed of a L-shaped bent plate; a pair of (left-hand and right-hand in FIG. 6) LM guides 11a and 11b for guiding the shoulder plate 9 when lifted or lowered; and a belt transmission mechanism 12 for lifting and lowering the shoulder plate 9. The belt transmission mechanism 12 is composed of an upper drive-side pulley 13a and a lower follower-side pulley 13b; a timing belt 14 extended between and wound around these pulleys; the reducer-equipped drive motor 15 connected to the drive-side pulley 13a so as to transmit its rotational output directly to the drive-side pulley 13a; the counter shaft 16 for transmitting the rotational output of the motor 15 to the driven-side lifting apparatus portion 7b; and a tensioner 17 for adjusting the tension of the timing belt 14.

As shown in FIG. 6, the shoulder plate 9 assumes the shape of a generally rectangular plate whose one corner is cut in a rectangular shape. One side portion of the shoulder plate 9 opposite the side having the cut corner is secured to the timing belt 14. Thus, when the timing belt 14 travels, the shoulder plate 9 moves upward or downward together with the timing belt 14. Although not illustrated in detail, a projection is formed on the upper surface of a distal end portion of the arm 10. This projection fits into a concave portion formed on the bottom surface of the FOUP 3 to thereby stably support the FOUP 3 while positioning the same.

Accordingly, when the reducer-equipped drive motor 15 rotates in the regular direction or reverse direction, the drive-side pulley 13a of the drive-side lifting apparatus portion 7a rotates in the regular direction or reverse direction, and the driven-side pulley 13a of the driven-side lifting apparatus portion 7b simultaneously rotates in the regular direction or reverse direction via the counter shaft 16. As a result, the pair of belt transmission mechanisms 12 rotate in the regular direction or reverse direction at both sides of the lifting apparatus; i.e., in the drive-side lifting apparatus portion 7a and the driven-side lifting apparatus portion 7b. Consequently, the pair of shoulder plates 9 move upward or downward in the same manner together with the pair of arms 10.

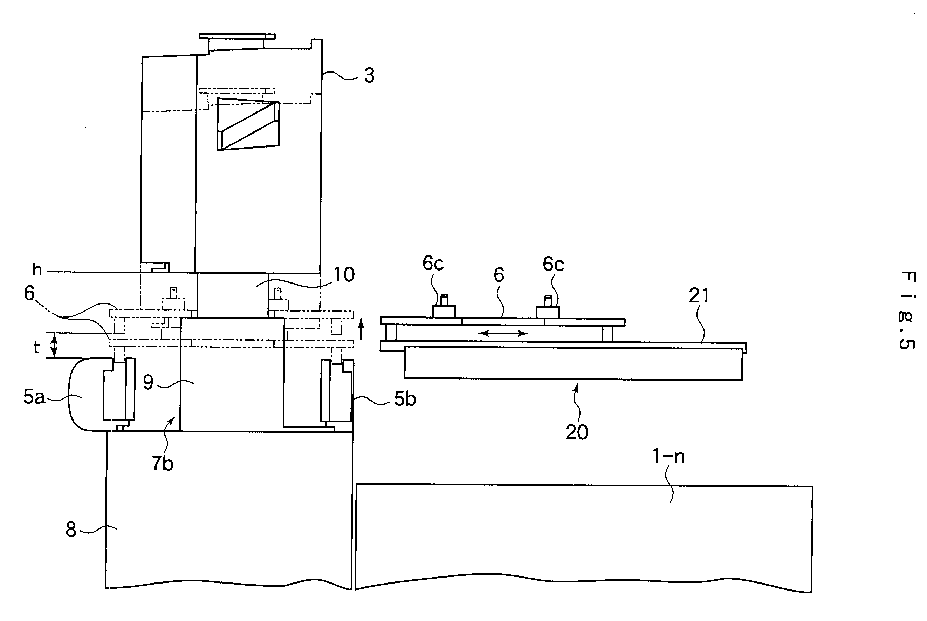

Here, the case where the reducer-equipped drive motor 15 rotates in the regular direction will be described. In this case, the pair of shoulder plates 9 move upward together with the pair of arms 10. The pair of arms 10 pass through the cut portions 6a and 6b of the front and rear portions of the pallet 6 standing by on the conveyor 5, hit the bottom surface of the FOUP 3 placed on the pallet 6, and scoop the FOUP 3 at front and rear end portions of the bottom surface. In the course of the FOUP 3 being lifted by the arms 10 to a position h (see FIG. 5) slightly higher than the conveyor 5, left-hand and right-hand shoulder portions of the shoulder plate 9 as viewed in the travel direction of the conveyor 5 hit the bottom surface of the pallet 6 at opposite edges of the opening end of each of the cut portions 6a and 6b, and scoop the pallet 6 at two locations in each of the front and rear end portions thereof (see a change in position of the pallet 6 illustrated by chain lines in FIG. 5).

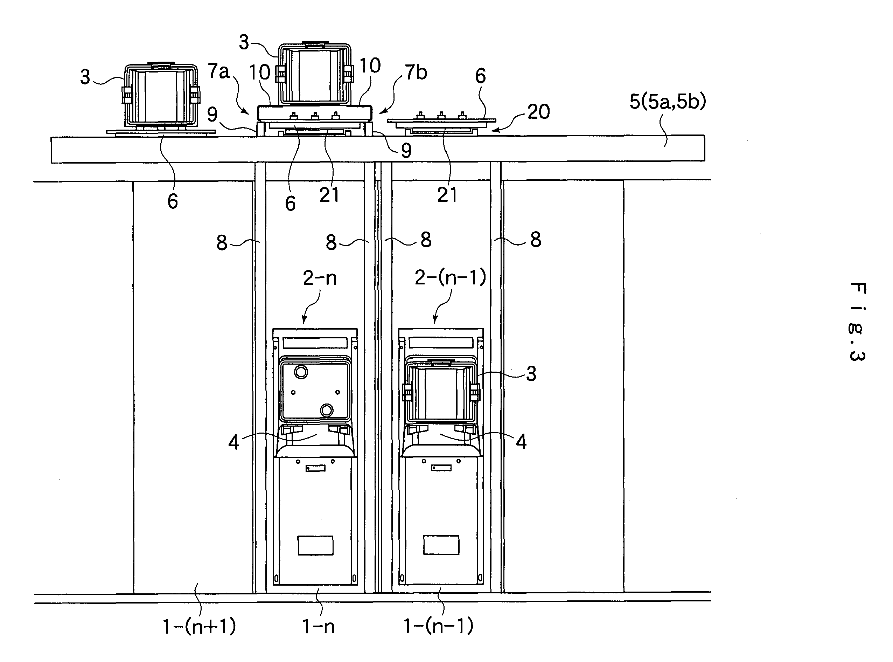

Once the FOUP 3 is lifted to the position h (shown in FIG. 5) slightly higher than the conveyor 5 by means of the lifting apparatus 7 (the arms 10), the FOUP 3 is held at that position, and similarly, the pallet 6 is held at a predetermined position corresponding to that position of the FOUP 3. FIGS. 1 to 4 show this state.

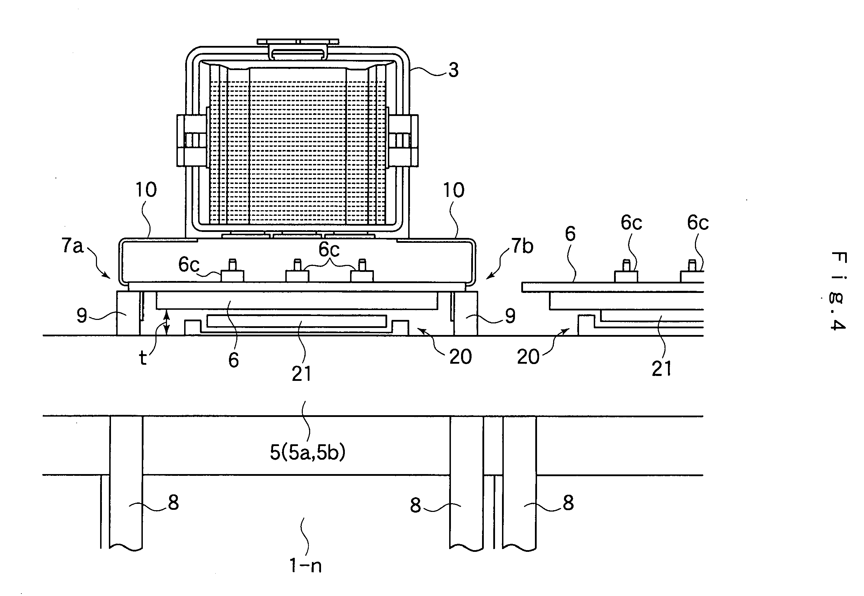

At that time, as shown in FIGS. 4 and 5, a slight gap t is formed between the pallet 6 and the conveyor 5 as viewed from a horizontal direction. A slider 21 of pallet insertion/removal means 20 to be described later enters this gap t, and then the shoulder plates 9 of the lifting apparatus 7 descend slightly, whereby the pallet 6 can be placed on the slider 21. Subsequently, the shoulder plates 9 of the lifting apparatus 7 further descend slightly, whereby the pallet 6 can be completely transferred to the slider 21. When the slider 21 is retreated in this state, the pallet 6 can be removed from a space above the conveyor 5. In contrast, when the slider 21 is advanced with the pallet 6 placed thereon, the pallet 6 can be inserted into the space above the conveyor 5. Hereinafter, the position of (the shoulder plates 9 of) the lifting apparatus 7 at which the slider 21 can remove the pallet 6 from the space above the conveyor 5 and insert the pallet 6 into the space above the conveyor 5 will be referred to a "pallet removal/insertion position."

Next, when the pallet 6 is to be placed on the conveyor 5, the lifting apparatus 7 operates as follows. The lifting apparatus 7 causes the pair of shoulder plates 9 to slightly ascend so that the left and right shoulder portions of the shoulder plates 9 push upward the pallet 6 at two locations in each of the front and rear portions thereof to thereby release the pallet 6 from the support by the slider 21. Thus, the slider 21 can be retracted. After that, the lifting apparatus 7 causes the pair of shoulder plates 9 to descend such that the left and right shoulder portions of the shoulder plates 9 are located below the upper end of the conveyor 5. Thus, the pallet 6 can be lowered and placed on the conveyor 5.

After that, when the lifting apparatus 7 causes the pair of shoulder plates 9 to descent further, the FOUP 3 can be lowered and placed on the pallet 6. In this manner, the FOUP 3 can be loaded on the conveyor line.

When the FOUP 3 is to be removed from the conveyor line, after the slider 21 carrying the pallet 6 thereon has been retreated to remove the pallet 6 from the conveyor 5, the lifting apparatus 7 causes the pair of shoulder plates 9 to continuously descend to a position under the conveyor 5 with the pair of arms 10 supporting the FOUP 3. When the pair of arms 10 pass the FOUP support surface of the load port 4 and reach a position slightly lower than the surface, the FOUP 3 is placed on the FOUP support surface of the load port 4. In order to prevent the internal end portions of the arms 10 from hitting the support surface of the load port 4, recesses are formed on the support surface.

The FOUP 3 placed on the support surface of the load port 4 is then advanced toward the wall portion of the processing apparatus 1-n, and the unillustrated opener operates so as to open the door of the FOUP 3, while preventing entry of ambient air, whereby transfer of the wafers between the FOUP 3 and the processing apparatus 1-n becomes possible.

After a predetermined process is performed on the wafers in the processing apparatus 1-n, the wafers are returned to the FOUP 3 through action of a robot within the processing apparatus. When the work of performing the predetermined process on a predetermined number of wafers is completed, the opener operates again to close the door of the FOUP 3.

Next, the shoulder plates 9 of the lifting apparatus 7 ascend so that the pair of arms 10 scoop the FOUP 3 placed on the support surface of the load port 4, and ascend while supporting the FOUP 3. Once the shoulder plates 9 of the lifting apparatus 7 ascend to the pallet removal/insertion position and the pallet insertion/removal means 20 inserts the pallet 6 into the space above the conveyor 5, the FOUP 3 can be returned to the conveyor line again in the manner as previously described.

The pallet insertion/removal means 20 is provided on the roof of each processing apparatus 1-n. A plurality of projection pins 6c are attached to the upper surface of each pallet 6. The projection pins 6c come into engagement with predetermined concave portions on the bottom surface of the FOUP 3 so as to position the FOUP 3 on the upper surface of the pallet 6 at a predetermined position, and hold the same in a stable condition.

By virtue of the above-described configuration, the present embodiment achieves the actions and effects as follows.
The lifting apparatus 7 enables the pallet insertion/removal means 20 to operate as follows in a state in which the lifting apparatus 7 has lifted the FOUP 3 to a position (pallet removal/insertion position) slightly higher than the conveyor 5 and holds the FOUP 3 at that position. Specifically, the insertion/removal means 20 inserts the pallet 6 into a space above the conveyor 5 or removes the pallet 6 from the space above the conveyor 5 in order to place the FOUP 3 into the conveyor line or remove the FOUP 3 from the conveyor line and lower the FOUP 3 to the load port 4. Therefore, through cooperation of two types of apparatus and means; i.e., the lifting apparatus 7 and the pallet insertion/removal means 20, the FOUP 3 on the conveyor 5 can be transferred to the load port 4 of a predetermined processing apparatus 1-n, and the FOUP 3 can be transferred from the load port 4 of the predetermined processing apparatus 1-n to the load port 4 of another predetermined processing apparatus via the conveyor 5. Therefore, the overall operation of the container transport apparatus is simplified, along with its control.

Further, during a period in which the FOUP 3 is removed from the conveyor line, lowered to the load port 4, and returned to the conveyor line through operation of the lifting apparatus 7 and the pallet insertion/removal means 20, movement along the conveyor line of a FOUP 3 located on the upstream side of the conveyor is not hindered. Moreover, since the FOUP 3 is conveyed by the conveyor 5 in a state in which the FOUP 3 is placed on the pallet 6, the FOUP 3 is transported in a more stable manner.

Further, the vertical wall 8 is provided between adjacent load ports 4, and the drive mechanism of the lifting apparatus 7 is attached to the vertical wall 8. Therefore, the vertical wall 8 serves as a safety cover, which prevents accidents such as easy falling of a FOUP 3 which is being transferred between the conveyor 5 and the load port 4 or a FOUP 3 placed on the load port 4, to thereby secure safety. Moreover, work safety can be secured for workers. In addition, since the vertical wall 8 serves as a mount portion for the drive mechanism of the lifting apparatus 7, the lifting apparatus 7 can be made compact.

Notably, the present invention is not limited to the above-described embodiment, and may be modified in various manners without departing from the scope of the invention.
For example, the container is not limited to a FOUP, and may be an SMIF (Standard Mechanical Interface). In this case, the FOUP opener is replaced with an SMIF opener.

## Claims

1. A container transport apparatus used to transport a container between a plurality of processing apparatuses within a bay area, the container airtightly storing articles, such as semiconductor wafers and liquid-crystal display panels, which are required to be transported with their surface kept uncontaminated, the container transport apparatus comprising:
a conveyor which is arranged in a ceiling space within the bay area to extend along a direction of arrangement of the plurality of processing apparatuses and which is adapted to move the container in a state where the container is placed on a pallet;
a lifting apparatus which is provided for each load port of the plurality of processing apparatuses disposed under the conveyor and which is adapted to lift and lower the container between the load port and the conveyor; and
a pallet insertion/removal means for inserting the pallet into a space above the conveyor and removing the pallet therefrom,
wherein the pallet insertion/removal means inserts the pallet for receiving the container into the space above the conveyor or removes the pallet therefrom in a state in which the lifting apparatus has lifted the container to a position slightly higher than the conveyor and holds the container at that position.

2. A container transport apparatus according to claim 1, wherein
a vertical wall is provided between adjacent load ports; and
a drive mechanism of the lifting apparatus is attached to the vertical wall.
